# EUROPÄISCHE PATENTSCHRIFT

(11) **EP 0 698 130 B1**
(45) Veröffentlichungstag und Bekanntmachung des Hinweises auf die Patenterteilung: **23.04.1997**
(21) Anmeldenummer: 94915040.3
(22) Anmeldetag: 13.05.1994
(51) Int. Cl.: C23C 18/44

(54) **VERFAHREN ZUR ABSCHEIDUNG VON PALLADIUMSCHICHTEN**
PROCESS FOR THE DEPOSITION OF PALLADIUM LAYERS
PROCEDE DE DEPOT DE COUCHES DE PALLADIUM

(30) Priorität: 13.05.1993 DE 4316679; 26.04.1994 DE 4415211
(43) Veröffentlichungstag der Anmeldung: 28.02.1996
(73) Patentinhaber: ATOTECH Deutschland GmbH, 10553 Berlin (DE)
(72) Erfinder: STEIN, Ludwig, D-14163 Berlin (DE); MAHLKOW, Hartmut, D-12159 Berlin (DE); STRACHE, Waltraud, D-13407 Berlin (DE)
(74) Vertreter: Effert, Udo, Dipl.-Ing.
(86) Internationale Anmeldenummer: DE9400572
(87) Internationale Veröffentlichungsnummer: WO9426954

(56) Entgegenhaltungen:
- EP-A- 0 525 282
- US-A- 4 804 410

## Beschreibung

Die Erfindung betrifft ein Verfahren zur Abscheidung von Palladiumschichten auf Metalloberflächen, ein Bad zur Durchführung sowie die Verwendung des Verfahrens.

Unedle Metalle können vor dem Angriff aggressiver Gase oder Flüssigkeiten durch widerstandsfähige Metallauflagen, deren Art im wesentlichen durch den Verwendungszweck bestimmt ist, geschützt werden. So wird Eisen/Stahl vor dem Anrosten durch dünne Kupferschichten geschützt, beispielsweise Schweißdraht. In der Elektronikindustrie verwendet man überwiegend Gold zum Schutz zu bondender oder zu lötender Flächen und von Kontaktflächen. Silber wird wegen der Migrationsneigung im allgemeinen nicht als Korrosionsschutz eingesetzt.

Auch Nickelschichten können als Korrosionsschutz, beispielsweise von Kupfer oder Kupferlegierungen, verwendet werden. Hierzu werden die Oberflächen zunächst oberflächlich aktiviert. Anschließend wird die zu beschichtende Ware in eine saure Palladiumlösung getaucht, so daß feinste Palladiumpartikel gebildet werden, an denen die Abscheidung des Nickels startet. Der Palladiumüberzug ist dabei nicht geschlossen und sehr fein verteilt. Die Oberflächen sehen grau aus. Der anschließende Nickelaufbau verschließt die Oberfläche vollständig. Allerdings sind die gebildeten Nickelschichten nicht oxidationsbeständig, daher nach Lagerung auch nicht löt- und bondbar und für den Einsatz als Korrosionsschutz in der Leiterplattentechnik nicht geeignet.

Für Anwendungszwecke, bei denen die Korrosionsschutzschicht auch als löt- und bondbare Endschicht verwendet werden soll, werden überwiegend Edelmetalle als Korrosionsschutzschicht eingesetzt. Palladium wird wegen dessen relativ niedriger Edelmetallkosten bevorzugt. Für die chemische Abscheidung von Palladiumschichten ist eine Vielzahl von verschiedenen Bädern bekannt (US-PS 4,424,241, US-PS 3,418,143, US-PS 3,754,939, DE-OS 42 01 129, GB-PS 1,164,776, DE-OS 30 00 526, US-PS 4,341,846, US-PS 4,255,194, DE-OS 28 41 584, EP-0 423 005 A1).

Innerhalb der US-Patentschrift 4,424,241 wird ein Verfahren zur chemischen Abscheidung von Palladium beschrieben, das bei einem kleineren pH-Wert als 2 arbeitet und in dem unter anderem Methansäure als Reduktionsmittel verwendet wird. Als Komplexbildner werden neben Carbonsäuren auch Amine angegeben, jedoch werden keine Angaben über die Art der verwendbaren Amine gemacht. Aus Vergleichsversuchen geht hervor, daß die aus diesen Bädern abgeschiedenen Palladiumschichten schwarz sind, nur ungenügend auf dem Substrat haften und sich die Bäder sehr schnell zersetzen. Es wird angegeben, daß die Gefahr spontaner Selbstzersetzung des Bades besteht, wenn die Konzentration des Reduktionsmittels zu hoch eingestellt wird.

In US-PS 3,285,754 wird ein zementatives Bad zur Abscheidung von Palladium auf Kupfer und Kupferlegierungen und anderen Substraten beschrieben, das Nitrito-Palladium-Komplexe enthält und im pH-Bereich zwischen 2 und 5 arbeitet. Der Palladiumkomplex enthält zudem komplexgebundene Säureanionen, beispielsweise Sulfat, Acetat und Chlorid. Die mit den beschriebenen Bädern herstellbaren Schichten sind außerordentlich dünn und enthalten Poren.

Nach DE-OS 42 01 129 wird ein Verfahren zur Herstellung einer Verdrahtungsplatte durch stromlose Palladiumplattierung auf den Kupferteilen der Platte beschrieben. Als Palladiumbäder werden bekannte Palladiumbeschichtungslösungen verwendet, die als Reduktionsmittel beispielsweise unterphosphorige Säure, phosphorige Säure oder hydrierte Borverbindungen, nicht jedoch Methansäure enthalten. Hierbei werden die Beschichtungslösungen mit den durch die Oxidation der angegebenen Reduktionsmittel entstehenden Reaktionsprodukten, beispielsweise Phosphit, Phosphat oder Borat, angereichert, so daß die Abscheidungsbedingungen schlechter werden, beispielsweise durch geringere Stabilität des Bades gegen Selbstzersetzung.

Der vorliegenden Erfindung liegt von daher das Problem zugrunde, die Nachteile des Standes der Technik zu vermeiden und ein geeignetes Verfahren zur Abscheidung vorzüglich haftender, glanzerhaltender, porenarmer Palladiumschichten auf Metalloberflächen zu finden. Auf den palladinierten Oberflächen sollen sich weiterhin bei Temperaturen bis 280 °C und Verweilzeiten von einigen Stunden keine oxidierenden Verbindungen bilden, so daß diese nach einer Lagerung an Luft von mindestens 2 bis 4 Wochen Dauer noch einwandfrei lötbar sind.

Gelöst wird das Problem durch die Patentansprüche 1, 8 und 13. Bevorzugte Ausführungsformen der Erfindung sind in den Unteransprüchen angegeben.

Es hat sich gezeigt, daß Palladiumschichten mit den beschriebenen Vorteilen aus einem formaldehydfreien chemischen Palladiumbad abgeschieden werden können. Die Beschichtung gelingt bereits mit einem kurzen Beschichtungsverfahren.

Es ist jedoch auch möglich, die Metalloberflächen, die aus Kupfer, Silber, Nickel und Kobalt sowie deren Legierungen untereinander und/oder mit Phosphor oder Bor bestehen können, vor der Palladiumabscheidung in dem formaldehydfreien chemischen Bad in einem zementativen Palladiumbad zu aktivieren, dem neben einem Palladiumsalz ein Oxidationsmittel zugesetzt wird.
Für dieses Bad können beliebige Palladiumsalze eingesetzt werden, beispielsweise Palladiumsulfat, Palladiumnitrat oder Palladiumperchlorat. Die Konzentration an Palladiumsalz beträgt etwa 0,005 bis 20 g/Liter, vorzugsweise 0,1 bis 2,0 g/Liter.

Als Oxidationsmittel, die in einer Konzentration von 0,01 bis 100 g/Liter, vorzugsweise 0,2 g/Liter bis 5,0 g/Liter, zugesetzt werden können, sind beispielsweise Peroxodisulfate, Perchlorate, Chlorate, Perborate, Periodate, Peroxide, wie Wasserstoffperoxid und/oder Nitrate von Alkali-, Erdalkalimetallen oder Ammonium einsetzbar.
Zur Einstellung eines sauren pH-Wertes kann dem zementativen Bad ein saures Salz, beispielsweise Natriumhydrogensulfat und/oder eine Säure, beispielsweise Schwefelsäure oder Salpetersäure, zugegeben werden.

Bevorzugte Anwendungsbereiche für die chemische Palladiumabscheidung sind die Leiterplattentechnik, ferner die Herstellung von elektronischen Bauelementen, wie beispielsweise Hybridschaltungen und Trägern für integrierte Schaltkreise, bei denen die Palladiumschichten im allgemeinen auf die mit den angegebenen Metallen beschichteten Kupferflächen, oder auf die Kupferflächen selbst, aufgebracht werden, und die Herstellung von Mikroelektrodenarrays. Weiterhin können derartige Palladiumschichten auch als Korrosions- und Lötschutzschichten eingesetzt werden.

Bei Anwendung des erfindungsgemäßen Verfahrens in der Leiterplattentechnik werden die aus Kupfer bestehenden Substratoberflächen vor der Palladiumabscheidung zunächst gereinigt. Hierzu dienen üblicherweise eine Ätzreinigung in oxidierenden, sauren Lösungen, wie beispielsweise einer schwefelsauren Wasserstoffperoxid-Lösung, und anschließend nochmals eine Reinigung in einer sauren Lösung, wie einer Schwefelsäure-Lösung. Danach werden die Oberflächen mit einer Palladiumionen enthaltenden Lösung, beispielsweise einer salzsauren Palladiumchlorid-Lösung, aktiviert und anschließend mit handelsüblichen chemischen Nickelbädern vernickelt. Im allgemeinen werden in diesem Fall Nickel/Phosphor-Schichten abgeschieden, indem zur Abscheidung Lösungen verwendet werden, die Natriumhypophosphit oder hypophosphorige Säure als Reduktionsmittel enthalten. Jedoch können auch Nickel/Bor-Schichten oder reine Nickelschichten abgeschieden werden. Anstelle von Nickel können auch Kobalt oder dessen Legierungen mit Phosphor oder Bor oder Nickel/Kobalt-Legierungen oder deren Legierungen mit Phosphor oder Bor abgeschieden werden.

Danach können die Oberflächen in einem Fall getrocknet und anschließend mit Vorbehandlung in dem zementativen Palladiumbad und anschließender Behandlung mit dem formaldehydfreien chemischen Palladiumbad oder ohne Vorbehandlung mit dem zementativen Palladiumbad gleich mit dem formaldehydfreien chemischen Palladiumbad behandelt werden. Es ist auch möglich, die Oberflächen lediglich zu spülen und anschließend ohne weitere Trockenschritte mit oder ohne Vorbehandlung mit dem zementativen Palladiumbad in dem formaldehydfreien chemischen Palladiumbad mit Palladium zu beschichten.

Technisch brauchbare Schichten, die die eingangs erwähnten Eigenschaften aufweisen, werden in nur 5 Minuten langer Tauchzeit in dem formaldehydfreien chemischen Bad abgeschieden. Die Dicke der abgeschiedenen Schicht beträgt in diesem Fall ca. 0,2 µm.

Das Bad enthält im wesentlichen ein Palladiumsalz, einen oder mehrere stickstoffhaltige Komplexbildner und Methansäure oder Methansäurederivate. Der pH-Wert der Lösung liegt oberhalb von 4, vorzugsweise im Bereich von 5 bis 6.

Als Palladiumsalze können beliebige Palladiumverbindungen einsetzt werden, beispielsweise Palladiumchlorid, Palladiumsulfat, Palladiumnitrat oder Palladiumacetat.

Als Reduktionsmittel eignet sich nicht nur die Methansäure selbst. Auch deren Derivate, beispielsweise die Ester dieser Säure, wie Methansäureethylester, die substituierten und unsubstituierten Amide, wie Formamid und N,N-Dimethylformamid, die Salze der Methansäure wie beispielsweise Natriumformiat, Additionsverbindungen und aktivierte Ameisensäure, wie Orthoameisensäure, können verwendet werden. Als Kationen der Methansäuresalze (Formiate) sind beispielsweise die Elemente der ersten, zweiten und dritten Hauptgruppe, insbesondere Lithium, Natrium, Kalium, Magnesium, Calcium und Aluminium einsetzbar. Darüber hinaus sind solche Formiate einsetzbar, bei denen als Kation Ammonium oder quaternäre Ammoniumverbindungen enthalten sind.

Die Verwendung von Methansäure oder Methansäurederivaten als Reduktionsmittel im Verfahren ist vorteilhaft, da diese Verbindungen im Gegensatz zu Formaldehyd nicht gesundheitsschädlich sind und da bei deren Oxidation während der Palladiumabscheidung keine schädlichen Nebenprodukte, sondern lediglich Wasserstoff und Kohlendioxid entstehen. Kohlendioxid reichert sich bei Verwendung eines sauren formaldehydfreien chemischen Bades in der Lösung nicht an, und Wasserstoff entweicht spontan aus dem Bad.

Als stickstoffhaltige Komplexbildner werden bevorzugt primäre, sekundäre oder tertiäre Amine oder Polyamine eingesetzt. Es werden beispielsweise die Verbindungen Ethylendiamin, 1,3-Diaminopropan, 1,2-Bis(3-aminopropylamino)-ethan, 2-Diethylaminoethylamin und Diethylentriamin verwendet.

Weiterhin lassen sich Diethylentriaminpentaessigsäure, Nitroessigsäure, N-(2-Hydroxyethyl)-ethylendiamin, Ethylendiamin-N,N-diessigsäure, 2-(Dimethylamino)-ethylamin, 1,2-Diaminopropylamin, 1,3-Diaminopropylamin, 3-(Methylamino)-propylamin, 3-(Dimethylamino)-propylamin, 3-(Diethylamino)-propylamin, Bis(3-aminopropyl)-amin, 1,2-Bis(3-aminopropyl)-alkylamin, Diethylentriamin, Triethylentetramin, Tetraethylenpentamin, Pentaethylenhexamin und beliebige Gemische dieser stickstoffhaltigen Komplexbildner verwenden.

Der Gehalt der Komplexbildner im Bad hängt vom Palladiumgehalt ab. Typischerweise werden Molverhältnisse der Komplexbildner zu Palladium von 5 bis 50 zu 1 verwendet, wobei der Gehalt der Komplexbildner im Bad 0,05 g/Liter bis 100 g/Liter Bad beträgt.

Der pH-Wert der Beschichtungslösung liegt oberhalb von 4. Bei pH-Werten unter 4 wird die Lösung instabil und neigt unter Wasserstoff-Entwicklung zur Selbstzersetzung. Während auf den Metalloberflächen bei geringer Unterschreitung des pH-Wertes von 4 vor allem schlechthaftende und dunkle Palladiumschichten erhalten werden, fällt bei pH-Werten unterhalb von etwa 2 Palladium aus der Lösung sogar aus. In diesem Falle werden schwarze und ungenügend auf der Unterlage haftende Niederschläge erhalten.

Der bevorzugte pH-Wert der Beschichtungslösung liegt im Bereich von 5 bis 6. Bei pH-Werten oberhalb von 7 steigt die Neigung des Bades, daß sich Palladium zementativ, d.h. nicht hellglänzend und auf der Unterlage festhaftend, auf den Metalloberflächen ablagert. Ferner greifen alkalische Beschichtungslösungen die auf den Leiterplatten aufgebrachten organischen Resistfilme, beispielsweise Lötstopmasken, an.

Bei Bädern mit hoher Abscheidungsrate, die mit einer Palladiumkonzentration von über 2 g/Liter und höherer Badtemperatur, beispielsweise über 50 °C, oder einer Badbeladung (Warenfläche pro Badvolumen) oberhalb von 2 dm²/Liter erreicht wird, ist es zweckmäßig, Stabilisatoren in einer Konzentration von 0,1 bis 100 Milligramm/Liter zuzugeben. Solche Stabilisatoren sind Verbindungen der Elemente Schwefel, Selen, Tellur, Kupfer, Nickel, Eisen und Chrom, beispielsweise Mercaptobenzthiazol, Kaliumselenocyanat, Thioharnstoff und Kaliumferrocyanat.

Es konnte ferner festgestellt werden, daß die Stabilität der Bäder mittels Durchleiten von inerten Gasen, beispielsweise Luft oder Stickstoff, erhöht werden konnte.

Mit dem erfindungsgemäßen Verfahren lassen sich hochreine, duktile Palladiumüberzüge mit einer Geschwindigkeit bis zu 5 µm/Stunde abscheiden. Während der Palladium-Abscheidung wächst die Schichtdicke linear mit der Zeit. Daher lassen sich mit dem erfindungsgemäßen Bad auch dicke Palladiumschichten abscheiden.

Die Abscheidung wird vorzugsweise in herkömmlichen Tauchanlagen durchgeführt, bei denen die zu behandelnden Substrate in im wesentlichen in senkrechter Richtung in die in Behältern befindlichen Badlösungen eingetaucht werden. Es ist jedoch auch denkbar, daß die Substrate in horizontaler Richtung durch eine Behandlungsanlage hindurchbewegt werden und dabei zumindest teilweise mit den Badlösungen in Kontakt kommen, wie beispielsweise in einer Metallisierungsanlage zur selektiven Metallisierung von Kontaktflächen auf Leiterplatten.

Die nachfolgenden Beispiele dienen zur Erläuterung der Erfindung.

### I) Formaldehydfreie chemische Bäder

### Beispiel 1:

Ein Kupferblech wurde in üblicher Weise mit einer chemischen Nickel/Phosphor-Schicht überzogen und danach getrocknet. Das trockene Blech wurde in einem Bad mit der folgenden Zusammensetzung mit Palladium beschichtet:

| | |
|---|---|
| Palladiumacetat | 0,05 Mol/Liter |
| Ethylendiamin | 0,1 Mol/Liter |
| Natriumformiat | 0,2 Mol/Liter |
| Bernsteinsäure | 0,15 Mol/Liter |
| pH-Einstellung mit Methansäure auf 5,5 | |
| Temperatur: 67 °C. | |

Nach einer halben Stunde wies die Palladiumschicht eine Dicke von 1,7 µm auf. Die Porenfreiheit des Überzuges wurde mit dem zur Bestimmung der Korrosionsbeständigkeit von Überzügen üblicherweise verwendeten Salzsprühtest bewiesen.

### Beispiel 2:

Ein Kupferblech wurde in üblicher Weise mit einer galvanischen Mattnickelschicht überzogen und danach getrocknet. Das trockene Blech wurde in einem Bad mit der folgenden Zusammensetzung mit Palladium überzogen:

| | |
|---|---|
| Palladiumsulfat | 0,01 Mol/Liter |
| Ethylendiamin | 0,2 Mol/Liter |
| Natriumformiat | 0,3 Mol/Liter |
| Kaliumdihydrogenphosphat | 0,2 Mol/Liter |
| pH-Einstellung mit Methansäure auf 5,8 | |
| Temperatur: 63 °C. | |

Nach einer Expositionszeit von einer Stunde betrug die Palladiumschichtdicke 3,8 µm. Poren konnten mit dem Salzsprühtest nicht nachgewiesen werden.

### Beispiel 3:

Ein Kupferblech wurde in üblicher Weise mit einer galvanischen Glanznickelschicht überzogen und danach getrocknet. Das trockene Blech wurde in einem Bad mit der folgenden Zusammensetzung mit Palladium überzogen:

| | |
|---|---|
| Palladiumacetat | 0,05 Mol/Liter |
| 1,2-Bis(3-aminopropylamino)-ethan | 0,1 Mol/Liter |
| Natriumformiat | 0,3 Mol/Liter |
| Bernsteinsäure | 0,1 Mol/Liter |
| pH-Einstellung mit Methansäure auf 5,9 | |
| Temperatur: 59 °C | |

Es wurde eine 1 µm dicke glänzende Schicht erhalten; Poren waren nicht mehr nachweisbar.

### Beispiel 4:

Eine verkupferte Leiterplatte wurde in üblicher Weise mit einer chemischen Nickel/Bor-Schicht überzogen und danach getrocknet. Anschließend wurde die Leiterplatte in einem Bad mit der folgenden Zusammensetzung mit Palladium überzogen:

| | |
|---|---|
| Palladiumdichlorid | 0,5 Mol/Liter |
| 2-Diethylaminoethylamin | 0,6 Mol/Liter |
| Methansäureethylester | 0,3 Mol/Liter |
| Kaliumdihydrogenphosphat | 0,2 Mol/Liter |
| pH-Einstellung mit Methansäure auf 6,0 | |
| Temperatur: 70 °C | |

Die Palladiumabscheidung wurde nach 10 Minuten abgebrochen, die Platte gespült und getrocknet. Ein Löttest mit dieser Platte zeigte ein hervorragendes Ergebnis.

### Beispiel 5:

Beispiel 1 wurde wiederholt. Auf dem Kupferblech wurde zunächst anstelle einer chemischen Nickel/Phosphor-Schicht eine chemische Kobalt/Phosphor-Schicht abgeschieden. Diese wurde anschließend mit der Palladiumschicht überzogen.

Es wurde ein hellglänzender, porenfreier Palladiumüberzug erhalten.

### Beispiel 6:

Ein nach Beispiel 1 hergestelltes Substrat wurde in einem Bad der folgenden Zusammensetzung beschichtet:

| | |
|---|---|
| Palladiumdichlorid | 0,01 Mol/Liter |
| 1,3-Diaminopropan | 0,025 Mol/Liter |
| Formamid | 0,05 Mol/Liter |
| Natriumcitrat | 0,1 Mol/Liter |
| pH-Einstellung mit verdünnter Salzsäure auf 7,0 | |
| Temperatur: 80 °C | |

Es wurde ebenfalls ein hellglänzender, porenfreier Palladiumüberzug erhalten.

### Beispiel 7

Ein nach Beispiel 1 hergestelltes Substrat wurde in einem Bad der folgenden Zusammensetzung beschichtet:

| | |
|---|---|
| Palladiumsulfat | 0,025 Mol/Liter |
| Ammoniumhydroxid | 0,125 Mol/Liter |
| N,N-Dimethylformamid | 0,05 Mol/Liter |
| Natriumboranat | 0,15 Mol/Liter |
| pH-Einstellung mit verdünntem Ammoniak auf 10,5 | |
| Temperatur: 65 °C | |

Es wurde ein hellglänzender, porenfreier Palladiumüberzug erhalten.

### Beispiel 8

Ein nach Beispiel 1 hergestelltes Substrat wurde in einem Bad der folgenden Zusammensetzung beschichtet:

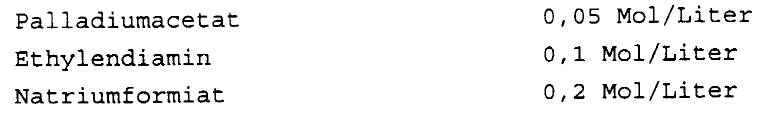

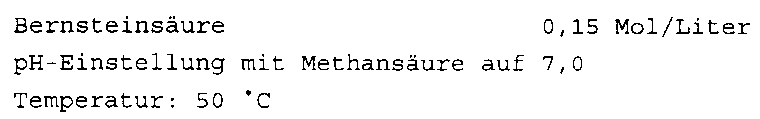

Es wurde ein hellglänzender, porenfreier Palladiumüberzug erhalten.

### Beispiel 9

Ein nach Beispiel 1 hergestelltes Substrat wurde in einem Bad der folgenden Zusammensetzung beschichtet:

| | |
|---|---|
| Palladiumsulfat | 0,01 Mol/Liter |
| Ethylendiamin | 0,2 Mol/Liter |
| Natriumformiat | 0,3 Mol/Liter |
| Kaliumdihydrogenphosphat | 0,2 Mol/Liter |
| pH-Einstellung mit Methansäure auf 7,0 | |
| Temperatur: 70 °C | |

Es wurde ein hellglänzender, porenfreier Palladiumüberzug erhalten.

### Beispiel 10

Ein nach Beispiel 1 hergestelltes Substrat wurde in einem Bad der folgenden Zusammensetzung beschichtet:

| | |
|---|---|
| Palladiumacetat | 0,05 Mol/Liter |
| 1,2-Bis(3-Aminopropylamino)-ethan | 0,1 Mol/Liter |
| Natriumformiat | 0,3 Mol/Liter |
| Bernsteinsäure | 0,1 Mol/Liter |
| pH-Einstellung mit Methansäure auf 7,0 | |
| Temperatur: 90 °C | |

Es wurde ein hellglänzender, porenfreier Palladiumüberzug erhalten.

### Beispiel 11

Ein nach Beispiel 1 hergestelltes Substrat wurde in einem Bad der folgenden Zusammensetzung beschichtet:

| | |
|---|---|
| Palladiumsulfat | 0,1 Mol/Liter |
| Ethylendiamin | 0,2 Mol/Liter |
| Natriumformiat | 0,3 Mol/Liter |
| Bernsteinsäure | 0,15 Mol/Liter |
| Hydroxyethansulfonsäure | 0,0003 Mol/Liter |
| pH-Einstellung mit Methansäure auf 8,5 | |
| Temperatur: 75 °C | |

Es wurde ein hellglänzender, porenfreier Palladiumüberzug erhalten.

### Vergleichsversuch:

Der Versuch nach Beispiel 1 wurde wiederholt. Jedoch wurde der pH-Wert der Palladiumlösung auf 1,0 eingestellt.

Das Bad war nicht stabil, sondern zersetzte sich unter Wasserstoff-Entwicklung und Palladium-Ausfällung. Auf dem Blech schlug sich ein schwarzer, matter Überzug nieder.

### II) Vorbehandlung mit sauren zementativen Bädern

### Beispiel 12

Ein Kupferblech wurde kathodisch elektrolytisch entfettet, nach dem Spülen kurz (einige Sekunden) in einer sauren Peroxodisulfatlösung angeätzt und nach einem weiteren Spülvorgang in einem Bad mit Palladium überzogen. Das Bad hatte folgende Zusammensetzung:

| | |
|---|---|
| Natriumhydrogensulfat | 30 g/Liter |
| Natriumnitrat | 3 g/Liter |
| Palladium (als Palladiumsulfat) | 0,2 g/Liter |
| Schwefelsäure | 0,6 g/Liter |

Behandlungsbedingungen:

| | |
|---|---|
| Temperatur | 40 °C |
| Behandlungszeit | 5 min |

Anschließend wurde das Blech in dem Palladiumbad gemäß Beispiel 1 beschichtet.
Das Kupferblech war mit einer weiß glänzenden Palladiumschicht überzogen. Der Metallüberzug haftete sehr gut (Tesatest). Die Lötfähigkeit, gemessen mit einer Benetzungswaage, war im Vergleich zu vergoldeten Flächen besser als diese. Nach 14 Tagen Lagerung konnte kein Abfall der Lötfähigkeit festgestellt werden. Die Porosität war sehr gering.

### Beispiel 13

Ein wie in Beispiel 12 vorbehandeltes Kupferblech wurde in einer wie folgt zusammengesetzten Lösung behandelt:

| | |
|---|---|
| Natriumhydrogensulfat | 20,0 g/Liter |
| Natriumperoxodisulfat | 0,7 g/Liter |
| Palladium (als Sulfat) | 0,2 g/Liter |
| Schwefelsäure | 0,6 g/Liter |

Behandlungsbedingungen:

| | |
|---|---|
| Temperatur | 40 °C |
| Behandlungszeit | 5 min |

Das Kupferblech war mit einer schwach grauen, jedoch glänzenden Palladiumschicht überzogen. Anschließend wurde das Blech in dem Palladiumbad gemäß Beispiel 1 beschichtet. Es wurde ein porenfreier Palladiumüberzug erhalten. Die Haftung des Palladiums war sehr gut (Tesatest). Die Lötbarkeit war vergleichbar zu der im Beispiel 12.

### Beispiel 14

Ein wie in Beispiel 12 vorbehandeltes Kupferblech wurde in einer wie folgt zusammengesetzten Lösung palladiniert:

| | |
|---|---|
| Natriumhydrogensulfat | 50,0 g/Liter |
| Kaliumperchlorat | 5,0 g/Liter |
| Palladium (als Sulfat) | 0,2 g/Liter |

Behandlungsbedingungen:

| | |
|---|---|
| Temperatur | 40 °C |
| Behandlungszeit | 5 min |

Nach der anschließenden Beschichtung des Blechs mit Palladium gem. Beispiel 1 war das Blech mit einer gleichmäßigen glänzenden Palladiumschicht überzogen, die die gleichen guten Eigenschaften aufwies, wie in Beispiel 12 beschrieben.

### Beispiel 15

Beispiel 12 wurde wiederholt, jedoch wurde das Kupferblech vor der Behandlung in dem sauren zementativen Palladiumbad zunächst mit einer Nickel/Phosphor-Schicht überzogen. Es wurden dieselben guten Ergebnisse erhalten.

### Beispiel 16

Beispiel 12 wurde mit einem sauren zementativen Palladiumbad der folgenden Zusammensetzung wiederholt:

| | |
|---|---|
| Palladiumnitrat | 0,3 g/Liter |
| Salpetersäure, konz. | 30 g/Liter |

Es wurden dieselben guten Ergebnisse erhalten.

### Beispiel 17

Beispiel 12 wurde mit einem sauren zementativen Palladiumbad der folgenden Zusammensetzung wiederholt:

| | |
|---|---|
| Natriumhydrogensulfat | 30 g/Liter |
| Natriumperborat | 0,05 g/Liter |
| Palladium (als Palladiumsulfat) | 0,2 g/Liter |
| Schwefelsäure | 0,6 g/Liter |

Es wurden dieselben guten Ergebnisse erhalten.

### Beispiel 18

Beispiel 12 wurde mit einem sauren zementativen Palladiumbad der folgenden Zusammensetzung wiederholt:

| | |
|---|---|
| Natriumhydrogensulfat | 30 g/Liter |
| Wasserstoffperoxid (30 Gew.-%) | 0,15 g/Liter |
| Palladium (als Palladiumsulfat) | 0,2 g/Liter |
| Schwefelsäure | 0,6 g/Liter |

Es wurden ebenfalls gute Ergebnisse erzielt.

### Beispiel 19

Zur Herstellung von Mikroelektroden wurde Polypropylenpulver für die Chromatographie (bspw. von der Fa. Polyscience, Inc., Warrington,USA) zunächst nach üblichen Verfahren vorbehandelt, aktiviert, chemisch vernickelt und anschließend mit dem formaldehydfreien chemischen Bad gemäß Beispiel 1 mit Palladium beschichtet.
Das mit Palladium beschichtete Pulver wurde anschließend zu Tabletten verarbeitet. Hierzu wurde das Pulver in ein Preßwerkzeug eingebracht. Danach wurde das Pulver langsam und schrittweise bis zum maximal für das Werkzeug zulässigen Preßdruck verpreßt.
Das Preßwerkzeug mit dem gepreßten Polypropylenpulver wurde in einen auf 210 °C vorgeheizten Ofen gebracht und 30 min lang erhitzt. Zur Fertigung des Mikroelektrodenarrays wurde danach eine Stirnfläche der so erhaltenen Tablette poliert und die andere Stirnfläche elektrisch kontaktiert.

### Beispiel 20

Ein Silberblech wurde mit einem sauren zementativen Palladiumbad der folgenden Zusammensetzung aktiviert:

| | |
|---|---|
| Palladiumnitrat | 0,3 g/Liter |
| Salpetersäure | 6,0 g/Liter |

Das Blech war nach 2 Minuten aktiviert und wurde nach einem Spülvorgang 15 Minuten lang in einem Palladiumbad, gemäß Beispiel 2, mit 1,2 µm Palladium beschichtet.
Der Palladiumüberzug war porenarm und verhinderte die Migration des Silbers.

## Patentansprüche

1. Verfahren zur Abscheidung von Palladiumschichten auf Metalloberflächen, aus einem formaldehydfreien chemischen Bad, enthaltend ein Palladiumsalz, einen oder mehrere stickstoffhaltige Komplexbildner und Methansäure oder Methansäurederivate bei einem pH-Wert oberhalb von 4.

2. Verfahren nach Anspruch 1, dadurch gekennzeichnet, daß der pH-Wert des formaldehydfreien, chemischen Bades im Bereich von 5 bis 6 liegt.

3. Verfahren nach Anspruch 1, dadurch gekennzeichnet, daß ein Aktivierungsschritt in einem sauren zementativen Bad, enthaltend ein Palladiumsalz und ein Oxidationsmittel oder ein Gemisch mehrerer Oxidationsmittel, vorgeschaltet ist.

4. Verfahren nach Anspruch 3, dadurch gekennzeichnet, daß als Oxidationsmittel Peroxodisulfate, Perchlorate, Perborate, Peroxide und/oder Nitrate verwendet werden.

5. Verfahren nach einem der Ansprüche 3 und 4, dadurch gekennzeichnet, daß das Oxidationsmittel oder das Gemisch mehrerer Oxidationsmittel in Konzentrationen von 0,01 bis 100 g/Liter zementatives Bad eingesetzt wird.

6. Verfahren nach einem der Ansprüche 3 bis 5, dadurch gekennzeichnet, daß als Palladiumsalz im zementativen Bad Palladiumsulfat, Palladiumnitrat oder Palladiumperchlorat in Konzentrationen von 0,005 bis 20 g/Liter Bad verwendet wird.

7. Verfahren nach Anspruch 1, gekennzeichnet durch Metalloberflächen aus Kupfer, Silber, Nickel und Kobalt sowie deren Legierungen untereinander und/oder mit Phosphor oder Bor.

8. Formaldehydfreies chemisches Bad zur Abscheidung von Palladiumschichten auf Metalloberflächen, enthaltend ein Palladiumsalz, einen oder mehrere stickstoffhaltige Komplexbildner und Methansäure oder Methansäurederivate bei einem pH-Wert oberhalb von 4.

9. Bad nach Anspruch 8, gekennzeichnet durch Salze, Amide oder Ester der Methansäure als Methansäurederivate.

10. Bad nach einem der Ansprüche 8 und 9, gekennzeichnet durch Alkalisalzformiat, Methansäureethylester, Formamid oder N,N-Dimethylformamid als Methansäurederivate.

11. Bad nach einem der Ansprüche 8 bis 10, gekennzeichnet durch primäre, sekundäre oder tertiäre Amine oder Polyamine als stickstoffhaltige Komplexbildner.

12. Bad nach einem der Ansprüche 8 bis 11, dadurch gekennzeichnet, daß die stickstoffhaltigen Komplexbildner in Konzentrationen von 0,05 bis 100 g/Liter darin enthalten sind.

13. Verwendung des Verfahrens nach einem der Ansprüche 1 bis 7 zur Herstellung von Leiterplatten, elektronischen Bauelementen, Korrosionsschutzschichten, Lötschutzschichten und/ oder Mikroelektrodenarrays.

## Claims

1. Method of depositing palladium layers on metal surfaces, from a chemical bath, which is free of formaldehyde and contains a palladium salt, one or more nitrogen-containing complexing agents and methanoic acid or methanoic acid derivatives at a pH value above 4.

2. Method according to claim 1, characterised in that the pH value of the chemical bath, which is free of formaldehyde, lies within the range of between 5 and 6.

3. Method according to claim 1, characterised in that an activation step is added in an acidic, cementative bath, containing a palladium salt and an oxidising agent or a mixture of a plurality of oxidising agents.

4. Method according to claim 3, characterised in that peroxodisulphates, perchlorates, perborates, peroxides and/or nitrates are used as the oxidising agents.

5. Method according to one of claims 3 and 4, characterised in that the oxidising agent or the mixture of a plurality of oxidising agents is used in concentrations of between 0.01 and 100 g/litre cementative bath.

6. Method according to one of claims 3 to 5, characterised in that palladium sulphate, palladium nitrate or palladium perchlorate is used as the palladium salt in the cementative bath in concentrations of between 0.005 and 20 g/litre bath.

7. Method according to claim 1, characterised by metal surfaces formed from copper, silver, nickel and cobalt as well as their alloys with one another and/or with phosphorus or boron.

8. Chemical bath, which is free of formaldehyde, for depositing palladium layers on metal surfaces, containing a palladium salt, one or more nitrogen-containing complexing agents and methanoic acid or methanoic acid derivatives at a pH value above 4.

9. Bath according to claim 8, characterised by salts, amides or esters of methanoic acid as the methanoic acid derivatives.

10. Bath according to one of claims 8 and 9, characterised by alkali salt formiate, methanoic acid ethyl ester, formamide or N,N-dimethylformamide as the methanoic acid derivatives.

11. Bath according to one of claims 8 to 10, characterised by primary, secondary or tertiary amines or polyamines as the nitrogen-containing complexing agents.

12. Bath according to one of claims 8 to 11, characterised in that the nitrogen-containing complexing agents are contained therein in concentrations of between 0.05 and 100 g/litre.

13. Use of the method according to one of claims 1 to 7 for producing printed circuit boards, electronic components, corrosion-preventing layers, solder-preventing layers and/or microelectrode arrays.

## Revendications

1. Procédé de dépôt de couches de palladium sur des surfaces métalliques, constitué d'un bain chimique sans formaldéhyde contenant un sel de palladium, un ou plusieurs complexants azotés et de l'acide formique ou des dérivés d'acide formique à un pH supérieur à 4.

2. Procédé selon la revendication 1, caractérisé en ce que le pH du bain chimique sans formaldéhyde se situe dans la gamme allant de 5 à 6.

3. Procédé selon la revendication 1, caractérisé en ce qu'une étape d'activation est faite en amont dans un bain de cémentation acide contenant un sel de palladium et un moyen d'oxydation ou un mélange de plusieurs moyens d'oxydation.

4. Procédé selon la revendication 3, caractérisé en ce qu'on utilise comme moyen d'oxydation des peroxodisulfates, des perchlorates, des perborates, des peroxides et/ou des nitrates.

5. Procédé selon l'une des revendications 3 et 4, caractérisé en ce que le moyen d'oxydation ou le mélange de plusieurs moyens d'oxydation est introduit à des concentrations de 0,01 à 100 g pour un bain de cémentation de 1 litre.

6. Procédé selon l'une quelconque des revendications 3 à 5, caractérisé en ce que comme sel de palladium dans le bain de cémentation, on utilise du sulfate de palladium, du nitrate de palladium ou du perchlorate de palladium à des concentrations de 0,005 à 20 g pour un bain de 1 litre.

7. Procédé selon la revendication 1, caractérisé par des surfaces métalliques en cuivre, en argent, en nickel et cobalt ainsi que constituées d'alliages de ceux-ci et/ou avec du phosphore ou du bore.

8. Bain chimique sans formaldéhyde pour le dépôt de couches de palladium sur des surfaces métalliques contenant un sel de palladium, un ou plusieurs complexants azotés et de l'acide formique ou des dérivés d'acide formique à un pH supérieur à 4.

9. Bain selon la revendication 8, caractérisé par des sels, des amides ou des esters de l'acide formique comme dérivés de l'acide formique.

10. Bain selon l'une quelconque des revendications 8 et 9, caractérisé par un formiate de sel alcalin, un éthylester d'acide formique, un formamide ou un N,N-diméthylformamide comme dérivés d'acide formique.

11. Bain selon l'une quelconque des revendications 8 à 10, caractérisé par des amines primaires, secondaires ou tertiaires ou des polyamines comme complexants azotés.

12. Bain selon l'une quelconque des revendications 8 à 11, caractérisé en ce que les complexants azotés sont contenus dans le bain à des concentrations de 0,05 à 100 g par litre.

13. Utilisation du procédé selon l'une quelconque des revendications 1 à 7 pour la fabrication de cartes de circuits imprimés, de composants électroniques, de couches de protection contre la corrosion, de couches de protection des soudures et/ou de réseaux de microélectrodes.
